# EUROPEAN PATENT APPLICATION

(11) **EP 1 313 186 A1**
(43) Date of publication of application: **21.05.2003**
(21) Application number: 01309724.1
(22) Date of filing: 19.11.2001
(51) Int. Cl.: H01S 5/14

(54) **Wavelength stabilised laser source comprising fibre grating**

(71) Applicant: Agilent Technologies, Inc. (a Delaware corporation), Palo Alto, CA 94303 (US)
(72) Inventor: Horley, Raymond John, Ipswich, Suffolk IP7 6QH (GB); Crouch, Jeremy Paul, Stowmarket, Suffolk IP4 6JB (GB)
(74) Representative: Coker, David Graeme

(57) **Abstract**

The present invention relates to the stabilisation of the lasing wavelength of a laser source using feedback from a fibre pigtail grating. An optical fibre (50) is first aligned and joined to a laser source (102), in particular a laser diode, so that laser output optical radiation (112) is coupled (52) into the fibre (50). One or more optical characteristics (66,78) of the laser source (102) are determined, such as optical power (68) vs. drive current (70) and the laser spectrum (78). A grating (132) is then formed in the optical fibre (50), which reflects back (97) into the laser source (102) a proportion of said optical radiation (52) coupled into the optical fibre. This has the effect of stabilising the output wavelength (80) of the laser source (102). The process helps to ensure that one or more optical characteristics (94,134) of said formed grating (132) are matched to the laser source (102) according to said one or more determined optical characteristics (66,78) of the laser source (102).

## Description

The present invention relates to the stabilisation of the lasing wavelength of a laser source using feedback from a fibre pigtail grating.

One way of stabilising the lasing wavelength of a laser source, particularly a laser diode, is to couple the output from the laser into an optical fibre pigtail having a grating. Such gratings are normally alternating bands of relatively high and low index of refraction, aligned transversely to the propagation direction of the optical radiation within the fibre. The grating is fabricated to selectively reflect a particular characteristic wavelength within the fibre back to the laser source. If the amount of the optical feedback is sufficient, then the wavelength of the laser diode can be stabilised against fluctuations owing to temperature variations of the laser, short-term power variations, or long-term ageing effects.

Such wavelength-stabilised laser sources are useful in fibre optical networks using wavelength division multiplexing (WDM), where different wavelengths launched into a fibre must have tightly-controlled wavelengths so as not to interfere with one another.

Another fibre optic application in which a high degree of wavelength stabilisation is useful, is in erbium-doped fibre amplification systems where the wavelength of the pump laser needs to be tightly controlled to match the absorption characteristics of the erbium-doped fibre. See, for example, the disclosure in patent document US 6,144,788.

There are two conventional methods of combining a laser diode with a fibre pigtail having a feedback grating. The first is to align and join an optical fibre having no such grating with a laser diode. The fibre may be prepared with a lensed input face, and/or positioned with respect to a micro-lens that collects and focuses the laser optical radiation into the optical fibre. There are many types of such known ways of joining a fibre to a laser source, and generally once a fibre is aligned and joined, this is a permanent arrangement owing to the difficulty and cost of achieving a good and stable alignment which maximises the efficiency of optical radiation coupled into the fibre.

Once the fibre has been aligned and joined, a free end of the fibre may be spliced to a second length of fibre having the fibre grating. Such splices have the disadvantage of losing about 10% of the optical radiation, owing to the optical discontinuity at that point. The assembly is then tested to ensure that the grating is matched to the laser diode. This is necessary for several reasons. Individual laser diodes will normally have slightly different optical and electrical characteristics, for example in terms of: the unstabilised lasing wavelength, the slope of the optical power vs. driving current curve, and changes in lasing wavelength with driving current and laser diode temperature.

Gratings can also be formed with different characteristics. The period of a grating will determine the strength of reflectivity from the grating as a function of the wavelength of the incoming optical radiation. The period of the grating, and hence the grating wavelength at which reflectivity is a maximum, can be selected in advance depending on the desired output wavelength of the stabilised laser source.

The other characteristic of the grating, is the strength of the grating, that is, the absolute reflectivity at the grating wavelength. The strength of the grating has to be matched to the optical characteristics of the laser. In general, there is an optimum range for the reflectivity of the grating. In the case of a laser diode, optical feedback tends to lower the power of the optical radiation for a given drive current when the drive current is relatively high, but not when the drive current is relatively low. As a result, there is a transition point in the optical power vs. drive current curve, below which the relationship is linear with a nearly constant slope, and above which, there is a sudden decrease in slope. This transition point needs to be at a power beyond the normal operating power of the laser diode, so that the laser diode characteristic is linear across its operating region.

Furthermore, the transition point needs to be beyond the normal operating region over the lifetime of the device, and across all expected operating conditions, particularly temperature of the device itself.

However, if the optical feedback is not sufficiently high, then the feedback may be insufficient to stabilise the laser wavelength at all times and across all operating conditions. If the wavelength is not stabilised, then it will normally be the case that the device is unusable.

Therefore, there is a tendency for the transition point to be close to the operating region of the laser diode at high output powers.

Because of the variation in laser optical characteristics, and different strengths of grating, once the fibre grating has been spliced to the joined laser and fibre, the combination must be tested to ensure that the grating is matched to the laser characteristics. For this purpose, the free end of the fibre grating normally has an optical output connector that can be mated to optical test equipment such as an optical power meter and spectrometer for measuring laser wavelength. If the wavelength is not stabilised, or if the operating region of the laser diode exceeds the transition point, then the grating is not well-matched to the laser diode. It is not normally possible to undo the splice or to disconnect the laser diode from the aligned fibre. The laser diode assembly, and particularly the fibre grating are relatively expensive components, and so if either the laser diode or grating are to be used again the fibre grating must then be cut away from the assembly. The ends of the aligned fibre and fibre grating must then be prepared again, prior to splicing to different components. Although this saves the cost of the fibre grating, typically about $200, this is inconvenient, time-consuming, and adds to overall production costs.

A known alternative approach is to align and join the fibre grating directly to the laser diode. This has the advantage of removing the production step of splicing the fibre grating to the aligned fibre, and also eliminates coupling losses at the splice. However, the problem is then worse if the fibre grating and laser are not well-matched, as it may be necessary to use more expensive alignment couplings that can be decoupled, or to cut the fibre grating, discard the laser diode unit, and prepare again a suitable end face on the fibre grating for joining to another laser diode assembly.

It is an object of the present invention to provide a more convenient method and apparatus for producing a wavelength-stabilising fibre grating coupled to a laser source.

According to the invention, there is provided a method for producing a wavelength-stabilising fibre grating coupled to a laser source, characterised in that the method comprises the steps of:
i) aligning and joining an optical fibre to the laser source, so that laser output optical radiation is coupled into the fibre;
ii) determining one or more optical characteristics of the laser source; and
iii) after step i), forming in the optical fibre a grating for reflecting back into the laser source a proportion of said optical radiation coupled into the optical fibre, in order to stabilise the output wavelength of the laser source, and one or more optical characteristics of said formed grating are matched to the laser source according to said one or more determined optical characteristics of the laser source.

Because the fibre grating is formed in accordance with the determined optical characteristics of the laser source, the grating is essentially customised to the laser source. This allows improvements in manufacturing yield and cost. It may also allow a greater range of variability in laser source optical characteristics, as the matching between the laser fibre grating is no longer a matter of chance. This may also help to improve yields and reduce costs for the laser sources used with the fibre gratings.

The method may be used to narrow the wavelength variation of a laser source, but is most useful when it is necessary that the wavelength of the laser source is stabilised to a single wavelength across a desired operating region of the laser source. The operating region may be defined in terms of factors such as, peak optical power, average or rms optical power, electrical power consumption, temperature, and expected lifetime or the number of operating hours of the laser source.

Preferably, step ii) occurs at least in part between steps i) and iii). Although the laser source optical characteristics could in principle be measured before the laser source is aligned and joined with the fibre, the presence of the fibre will in general affect the performance of the laser. It is therefore best if at least some of the step ii) is performed after step i).

The determined optical characteristics of the laser source may be used to choose desired optical characteristics of the grating prior to the formation of the grating in the fibre. For example, different batches of laser diode will in general have slightly different natural wavelengths, at which optical power is generated most efficiently. The desired wavelength for the stabilised laser assembly may then be chosen at a value consistent with efficient laser operation.

The optical radiation used to determine the optical characteristics of the laser source may be obtained directly from the source itself, but is preferably coupled out of the optical fibre. In a preferred embodiment of the invention, the fibre has a free end, and the one or more optical characteristics of the laser source are determined from optical radiation emitted by this free end of the optical fibre.

It may be particularly helpful if step ii) occurs at least in part during step iii). The performance of the laser source will, of course, be affected by the presence of the grating being formed. If the optical characteristics of the laser source are determined at least in part during this phase, then it is possible to obtain a more reliable and precise control over the match between the laser source and the fibre grating.

In a similar manner, one or more optical characteristics of the grating being formed may be determined from optical radiation emitted by a free end of the optical fibre.

The matched optical characteristics of the grating may include any or all of: the strength of the grating; the characteristic wavelength of the grating; and the location of the grating on the fibre.

When the laser source is electrically driven, one of the determined optical characteristics of the laser source may be the optical power vs. drive current characteristic of the laser.

Other determined optical characteristics of the laser source include the optical power characteristic vs. wavelength of the laser.

It will often be the case that one of the determined optical characteristics of the laser source is a temperature-dependent characteristic in the absence of wavelength stabilisation by the grating. For example, the wavelength of a laser diode tends to shift to longer wavelengths as a laser diode heats up.

Also according to the invention, there is provided an apparatus for making a wavelength-stabilising fibre grating coupled to a laser source, characterised in that the apparatus comprises:
i) means for aligning and joining an optical fibre to the laser source, so that laser output optical radiation is coupled into the fibre;
ii) means for determining one or more optical characteristics of the laser source; and
iii) means for forming in the optical fibre a grating for reflecting back into the laser source a proportion of said optical radiation coupled into the optical fibre, in order to stabilise the output wavelength of the laser source, such that one or more optical characteristics of said formed grating are matched to the laser source according to said one or more determined optical characteristics of the laser source.

The invention will now be described in further detail, and by way of example only, with reference to the accompanying drawings, in which:
Figure 1 is a schematic view of a prior art wavelength-stabilising fibre grating, having a laser diode joined to a fibre to which is spliced to another fibre having a pre-formed fibre grating; and
Figures 2 and 3 are a schematic views showing how a wavelength-stabilising fibre grating is formed according to the invention, from a laser diode joined to a fibre in which a grating is subsequently formed.

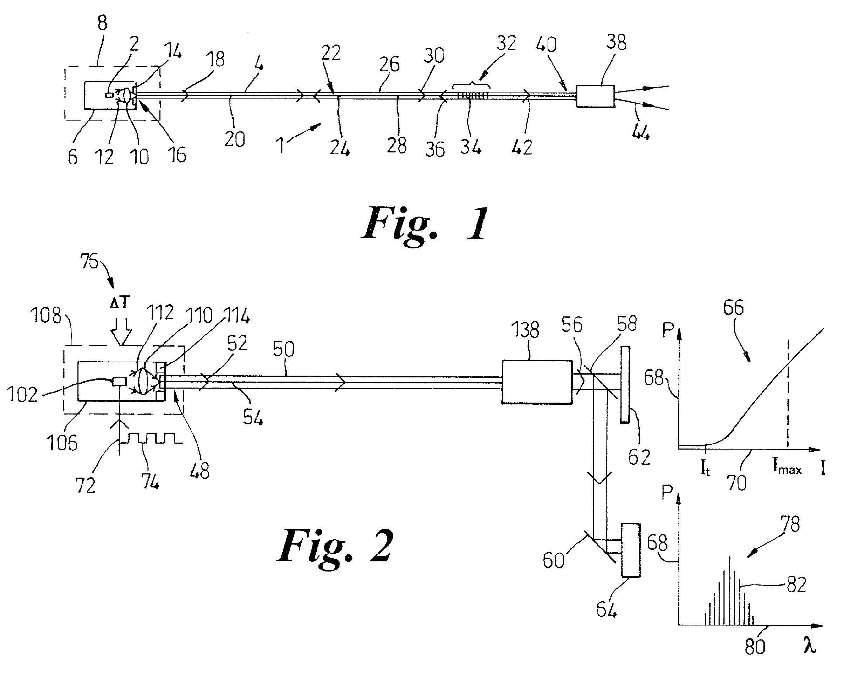

Figure 1 shows a prior art optical assembly 1, comprising a semiconductor laser 2, here an infra-red laser diode, joined to a short length of single-mode optical fibre 4, typically about 1 m long. The laser diode 2 is mounted on a substrate 6 within a laser diode module 8 that will normally contain other conventional components (not shown) such as a monitor photodiode, drive electronics, and a thermoelectric cooler.

Mounted on the substrate 6 are a collimating lens 10 positioned to collect and focus optical radiation 12 from the laser diode 2, and a fibre mount 14 for receiving one end 16 of the fibre 4. The fibre 4 is aligned and joined to the laser diode by the fibre mount 14, so that the focussed optical radiation is launched 18 into a single-mode core 20 of the fibre 4.

Once the fibre 4 has been successfully joined to the laser diode 2, an initially free end 22 of the fibre 4 is then joined at a splice 24 to a second short length of optical fibre 26, usually about 1 m to 2 m long. The second fibre 26 has a similar single-mode core 28, that needs to be aligned to an accuracy of about 1 µm with respect to the first core 20 for good coupling efficiency, e.g. better than 90%, of optical radiation 30 into the second fibre 26.

The second fibre, referred to hereinafter as a "grating fibre" 26, has a pre-formed optical grating 32, consisting of a plurality of alternating bands 34 of high and low reflective index. Optical radiation 30 with a wavelength λ coupled into the grating fibre 26 is then partially reflected 36 by the grating 32. Most of the reflected optical radiation 36 is coupled via the first fibre 4 and collimating lens 10 back into the laser diode 2. Depending on the optical characteristics of the laser diode 2 and the grating 32, an optimum amount for the reflected optical radiation 36 is between about 2% and 10%, and typically 5%.

An optical fibre output connector 38 may be joined to a free end 40 of the grating fibre 26, either before or after the grating fibre is spliced to the first fibre 4. The coupler 38 receives optical radiation transmitted 42 by the grating 32. Most of this radiation is then available 44 from the coupler 38 either for test purposes for measuring the optical characteristics of stabilised optical radiation 44 during manufacture, or for use as a stabilised source of optical radiation 44 in a finished product.

As described in the introduction, this arrangement suffers from a number of inconveniences, because the optical characteristics of the grating 32 may not be properly matched to the optical characteristics of the laser diode 2 and intervening optics 10.

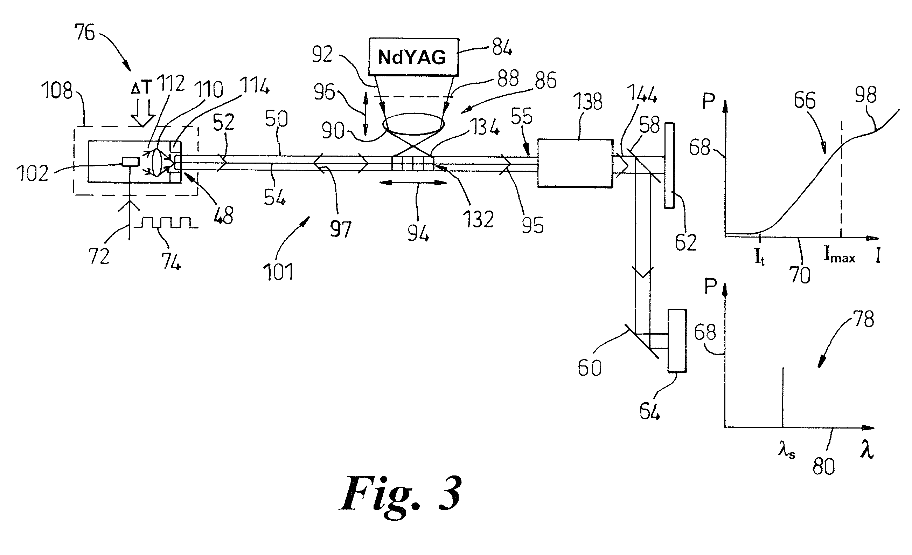

A process for producing a wavelength-stabilising fibre grating coupled to a laser source according to the invention, is illustrated schematically in Figures 2 and 3. Components similar to those of Figure 1 are denoted by reference numerals incremented by 100.

A conventional laser diode module 108 having a laser source 102 and a fibre mount 114, similar to that described above, is first aligned and joined to a free end 48 of a short length of single-mode optical fibre 50, about 2 m to 3 m long. Optical radiation is launched 52 into a core 54 of the fibre towards an output connector 138 joined to a free end 55 of the fibre 50. Most of the launched optical radiation is then available 56 from the connector 138 and may, for example, be coupled into an optical fibre (not shown) or directed by means of conventional optics such as a beam splitter 58 and mirror 60 towards optical test instrumentation such as an optical power meter 62 or wave meter 64 to enable the optical characteristics of the optical radiation 56 to be determined.

The power meter 62 can be used to generate a plot 66 of optical power (P) 68 against the drive current (I) 70 used to energise the laser diode 102. The drive current 70 is supplied to the laser diode 102 via an input line 72 connected to the laser diode 102. The current I may be a d.c. current, but may carry test signals 74 to enable the laser module 108 to be tested over a range of operating conditions. The operating conditions over which the laser module 108 is tested may include controlled temperature changes 76.

As shown in plot 66, the P vs. I characteristic of an unstabilised laser diode 102 is normally linear above a threshold current Iₜ. Laser diode operation is usually constrained below a rated maximum current Iₘₐₓ in order to ensure an adequate laser lifetime.

Because the fibre 50 initially has no grating, the wavelength λ of the optical radiation 52 is unstabilised, as shown by the spectrum plot 78 of laser power (P) 68 against wavelength (λ) 80, generated using the wave meter 64. The laser wavelength can hop amongst a number of modes 80, which will tend to drift to a longer wavelength with increased laser power and temperature.

Once the optical characteristics 66,82 of the laser diode 102 have been determined, then a grating 132 can be formed in the fibre 50, as shown in Figure 3. Because the laser characteristics are known, it is possible to select in advance the grating properties such a strength and pitch that are likely to stabilise the laser 102 in an optimum fashion.

The grating 132 can be formed using known techniques, such as a NdYAG laser 84 and optical imaging system 86 including a mask 88 and focussing optics 90, in order to irradiate the fibre with a sufficient intensity of optical radiation 92 to alter the refractive index of the fibre in bands 134 that extend transverse to the fibre core 54. The strength of the grating 132 can be controlled by the amount of exposure to the NdYAG optical radiation 92, and the pitch 94 of the grating can be controlled by adjusting 96 the components of the optical system 86.

Optionally, the NdYAG laser 84 and optical imaging system 86 can be moved longitudinally along the length of the fibre 50 to form the grating in a preferred location on the fibre 50.

During the formation of the grating 132, the optical radiation transmitted 95 by the grating and the output optical radiation 144 start to become wavelength-stabilised as a proportion of the launched optical radiation 52 is reflected 97 by the grating. During this process, the optical characteristics 66,78 of this stabilised radiation 144 continue to be monitored by the power meter 62 and wave meter 64. In particular, a kink 98 in the P vs. I optical characteristic 66 can be observed above the maximum operating current Iₘₐₓ. As the strength of the grating increases, this kink may move down the P vs. I curve 66 towards Iₘₐₓ as the wavelength λ becomes stabilised at the grating wavelength λ_{S}. The formation of the grating can then cease once the wavelength λ_{S} is sufficiently stabilised across the full operating region included temperature changes 76, and before the kink 98 in the P vs. I optical characteristic 66 drops as far as the upper end of the operating current at Iₘₐₓ.

It is also possible to deduce from the stabilised output optical radiation 144 optical characteristics of the grating 132. For example, as the grating 132 reflects more optical radiation 97 back towards the laser source 102, the measured output optical power (P) 68 will tend to drop.

This process therefore allows each grating 132 to be formed and optimally matched to the laser source 102 in a controlled manner that improves manufacturing yield and reduces cost.

The invention therefore provides a convenient and economical method and apparatus for forming a wavelength-stabilising fibre grating coupled to a laser source.

## Claims

1. A method for producing a wavelength-stabilising fibre grating (132) coupled to a laser source (102), **characterised in that** the method comprises the steps of:
i) aligning and joining an optical fibre (50) to the laser source (102), so that laser output optical radiation (112) is coupled (52) into the fibre (50);
ii) determining one or more optical characteristics (66,78) of the laser source (102); and
iii) after step i), forming in the optical fibre (50) a grating (132) for reflecting back (97) into the laser source (102) a proportion of said optical radiation (52) coupled into the optical fibre (50), in order to stabilise the output wavelength (80) of the laser source (102), and one or more optical characteristics (94,134) of said formed grating (132) are matched to the laser source (102) according to said one or more determined optical characteristics (66,78) of the laser source (102).

2. A method as claimed in Claim 1, in which step ii) occurs at least in part between steps i) and iii).

3. A method as claimed in Claim 1 or Claim 2, in which said determined optical characteristics (66,78) of the laser source (102) are used to choose desired optical characteristics (94,134) of the grating (132) prior to the formation of the grating (132) in the fibre (50).

4. A method as claimed in any preceding claim, in which said one or more optical characteristics (66,78) of the laser source (102) are determined from optical radiation (144) emitted by a free end (55) of the optical fibre (50)

5. A method as claimed in any preceding claim, in which step ii) occurs at least in part during step iii).

6. A method as claimed in any preceding claim, in which said one or more optical characteristics (94,134) of the grating (132) being formed are determined from optical radiation emitted by a free end (55) of the optical fibre (50).

7. A method as claimed in any preceding claim, in which the matched optical characteristics (94,134) of the grating (132) include any or all of: the strength (134) of the grating (132); the characteristic wavelength (λ_{S}) of the grating (132); and the location of the grating (132) on the fibre (50).

8. A method as claimed in any preceding claims, in which the laser source (102) is electrically driven (72), and one of the determined optical characteristics (66,78) of the laser source (102) is the optical power vs. drive current characteristic (66) of the laser source (102).

9. A method as claimed in any preceding claim, in which one of the determined optical characteristics (66,78) of the laser source (102) is the optical power vs. wavelength characteristic (78) of the laser source (102).

10. A method as claimed in any preceding claim, in which one of the determined optical characteristics (66,78) of the laser source (102) is a temperature-dependent characteristic (76) in the absence of wavelength stabilisation by the grating (132).

11. A method as claimed in any preceding claim, in which the wavelength (80) of the laser source (102) is stabilised to a single wavelength (λ_{S}) across a desired operating region of the laser source (102).

12. A method as claimed in any preceding claim, in which the laser source is a semiconductor laser (102).

13. An apparatus for making a wavelength-stabilising fibre grating (132) coupled to a laser source (102), **characterised in that** the apparatus comprises:
i) means (114) for aligning and joining an optical fibre (50) to the laser source (102), so that laser output optical radiation (112) is coupled (52) into the fibre (50) ;
ii) means (58,60,62,64) for determining one or more optical characteristics (66,78) of the laser source (102); and
iii) means (84,86) for forming in the optical fibre a grating (132) for reflecting back (97) into the laser source (102) a proportion of said optical radiation coupled (52) into the optical fibre (50), in order to stabilise the output wavelength (λ_{S}) of the laser source (102), such that one or more optical characteristics (94,134) of said formed grating (132) are matched to the laser source (102) according to said one or more determined optical characteristics (66,78) of the laser source (102).
